# EUROPEAN PATENT APPLICATION

(11) **EP 4 842 177 A1**
(43) Date of publication of application: **18.11.2026**
(21) Application number: 24917307.1
(22) Date of filing: 03.12.2024
(51) Int. Cl.: H10K 59/38, H10K 59/80, H10K 71/00, H10K 59/12, H10K 102/00

(54) **DISPLAY DEVICE AND MANUFACTURING METHOD THEREFOR**

(30) Priority: 08.01.2024 KR 20240002876
(71) Applicant: Samsung Display Co., Ltd., Yongin-si, Gyeonggi-do 17113 (KR)
(72) Inventor: BAEK, Moon Jung, Yongin-si, Gyeonggi-do 17113 (KR); NOH, Hyun Woo, Yongin-si, Gyeonggi-do 17113 (KR)
(74) Representative: Taor, Simon Edward William
(86) International application number: PCT/KR2024/019553
(87) International publication number: WO 2025/150710

(57) **Abstract**

A display device may include: a substrate including first, second, and third sub-pixel areas and a non-emission area corresponding to a boundary between the first, second, and third sub-pixel areas; a display element layer including light emitting elements respectively disposed in the first, second, and third sub-pixel areas on the substrate; a light conversion layer disposed on the display element layer, and including a bank disposed in the non-emission area; and a color filter layer disposed on the light conversion layer, and including first, second, and third color filters. One of the first, second, and third color filters may be disposed in the non-emission area.

## Description

### Technical Field

Various embodiments relate to a display device and a method of manufacturing the display device.

### Background Art

Flat panel display devices are used as substitutes for cathode ray tube display devices due to characteristics such as light weight and thinness. Representative examples of such flat panel display devices include liquid crystal display devices and organic light emitting display devices.

The display device may include a light emitting element that generates light, a color conversion component that converts the wavelength of light generated from the light emitting element, and a color filter layer disposed on the color conversion component. The color filter layer may include color filter layers that selectively transmit light in different colors.

### Detailed Description of Invention

### Technical Problem

Various embodiments are directed to a display device that adjusts a reflective color through a change in design.

Various embodiments are directed to a method of manufacturing a display device.

However, embodiments are not limited to those set forth herein. The above and other embodiments will become more apparent to one of ordinary skill in the art to which the disclosure pertains by referencing the detailed description of the disclosure given below.

### Technical Solution

An embodiment may provide a display device, including: a substrate including first, second, and third sub-pixel areas and a non-emission area corresponding to a boundary between the first, second, and third sub-pixel areas; a display element layer including light emitting elements respectively disposed in the first, second, and third sub-pixel areas on the substrate; a light conversion layer disposed on the display element layer, and including a bank disposed in the non-emission area; and a color filter layer disposed on the light conversion layer, and including first, second, and third color filters. One of the first, second, and third color filters may be disposed in the non-emission area.

In an embodiment, the light conversion layer may further include: a first layer disposed in the first, second, and third sub-pixel areas; and a second layer covering the first layer. The bank may be disposed in the non-emission area on the second layer.

In an embodiment, at least one of the first, second, and third color filters may contact the second layer.

In an embodiment, the light conversion layer may further include: a low refractive layer disposed on the second layer; and a third layer covering the low refractive layer.

In an embodiment, at least one of the first, second, and third color filters may contact the third layer.

In an embodiment, the first layer may be formed by a photolithography process.

In an embodiment, the first, second, and third color filters may be formed by a photolithography process.

An embodiment may provide a display device, including: a substrate including first, second, and third sub-pixel areas and a non-emission area corresponding to a boundary between the first, second, and third sub-pixel areas; a display element layer including light emitting elements respectively disposed in the first, second, and third sub-pixel areas on the substrate; a light conversion layer disposed on the display element layer, and including a bank disposed in the non-emission area; and a color filter layer disposed on the light conversion layer, and including first, second, and third color filters. Two of the first, second, and third color filters may be disposed in the non-emission area.

In an embodiment, the first and the second color filters may be disposed in the non-emission area. The first color filter may be disposed on the second color filter in the non-emission area.

In an embodiment, the light conversion layer may further include: a first layer disposed in the first, second, and third sub-pixel areas; and a second layer covering the first layer. The bank may be disposed in the non-emission area on the second layer.

In an embodiment, at least one of the first, second, and third color filters may contact the second layer.

In an embodiment, the light conversion layer may further include: a low refractive layer disposed on the second layer; and a third layer covering the low refractive layer.

In an embodiment, at least one of the first, second, and third color filters may contact the third layer.

In an embodiment, the first layer may be formed by a photolithography process.

In an embodiment, the first, second, and third color filters may be formed by a photolithography process.

An embodiment may provide a method of fabricating a display device, including: providing a substrate including first, second, and third sub-pixel areas and a non-emission area corresponding to a boundary between the first, second, and third sub-pixel areas; forming, on the substrate, a display element layer including light emitting elements respectively disposed in the first, second, and third sub-pixel areas on the substrate; forming, on the display element layer, a light conversion layer including a bank disposed in the non-emission area; and forming, on the light conversion layer, a color filter layer including first, second, and third color filters. Forming the color filter layer may include forming one of the first, second, and third color filters in the non-emission area on the light conversion layer.

In an embodiment, forming the light conversion layer may include: forming a first layer in the first, second, and third sub-pixel areas; and forming a second layer covering the first layer. The bank may be formed in the non-emission area on the second layer.

In an embodiment, forming the light conversion layer may include: forming a low refractive layer on the second layer; and forming a third layer covering the low refractive layer. At least one of the first, second, and third color filters may contact the third layer.

In an embodiment, the first layer may be formed by a photolithography process.

In an embodiment, the first, second, and third color filters may be formed by a photolithography process.

### Advantageous Effects

In a display device in accordance with embodiments of the present disclosure, a bank used to define a boundary between color conversion layers may be used to define areas where respective colors of light are emitted.

In the display device in accordance with embodiments of the present disclosure, the bank is used to define the areas where the respective colors of light are emitted, so that the degree of freedom in design of a color filter in a non-emission area can be enhanced.

In the display device in accordance with embodiments of the present disclosure, one or two layers of color filters are used in the non-emission area, thus making it possible to adjust a reflective color.

In the display device in accordance with embodiments of the present disclosure, one or two layers of color filters are used in the non-emission area, whereby the thickness of a planarization layer can be reduced. Consequently, the production cost of the display device may be reduced.

However, effects of the present disclosure are not limited to the above-described effects, and various modifications are possible without departing from the spirit and scope of the present disclosure.

### Description of Drawings

FIG. 1 is a schematic plan view illustrating a display device in accordance with embodiments.
FIGS. 2 to 4 are schematic plan views illustrating embodiments of the pixel of FIG. 1.
FIG. 5 is a schematic sectional view illustrating a display panel of FIG. 1.
FIG. 6 is a schematic diagram of an equivalent circuit of an embodiment of a sub-pixel included in the pixel of FIGS. 2 to 4.
FIG. 7 is a schematic sectional view illustrating an embodiment of the light emitting element of FIG. 6. FIG. 8 is a sectional view illustrating another embodiment of the light emitting element of FIG. 6.
FIG. 9 is a schematic sectional view illustrating an embodiment of a pixel including the light emitting element of FIG. 7 or 8.
FIG. 10 is a schematic sectional view illustrating a light conversion layer and a color filter layer of FIG. 9.
FIG. 11 is a schematic sectional view for describing the thickness of a bank of FIG. 10 according to the transmittance of a second color filter.
FIGS. 12 and 13 are schematic sectional views illustrating a light conversion layer and a color filter layer of the display device in accordance with embodiments.
FIG. 14 is a schematic sectional view illustrating a light conversion layer and a color filter layer of the display device in accordance with embodiments.
FIGS. 15 to 17 are schematic sectional views illustrating a light conversion layer and a color filter layer of the display device in accordance with embodiments.
FIG. 18 is a flowchart illustrating a method of fabricating the display device in accordance with embodiments.
FIGS. 19 to 23 are schematic diagrams illustrating a step S300 of FIG. 18.
FIGS. 24 and 25 are schematic diagrams illustrating a step S400 of FIG. 18.

### Modes of the Invention

Hereinafter, an embodiment of the present invention will be described in detail with reference to the attached drawings. In the following description, only parts required for understanding of operations in accordance with the present disclosure will be described, and explanation of the other parts will be omitted not to make the gist of the present disclosure unclear. Accordingly, the present disclosure is not limited to the embodiments set forth herein but may be embodied in other types. Rather, these embodiments are provided so that the present disclosure will be thorough and complete, and will fully convey the technical spirit of the disclosure to those skilled in the art.

It will be understood that when an element is referred to as being "connected" to another element, it can be "directly connected" to the other element or intervening "elements may be present" therebetween. The terminology used herein is for the purpose of describing particular embodiments only and is not intended to be limiting. In the specification, when an element is referred to as "including" a component, it does not preclude another component but may further include other components unless the context clearly indicates otherwise. "at least one of X, Y, and Z" and "at least one selected from the group consisting of X, Y, and Z" may be construed as X only, Y only, Z only, or any combination of two or more of X, Y, and Z (for instance, XYZ, XYY, YZ, and ZZ). As used herein, the term "and/or" can include any and all combinations of one or more of the associated listed items.

Although the terms first, second, etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "under", "on", and the like, may be used herein for descriptive purposes, and, thereby, to describe one element or feature's relationship to another element(s) or feature(s), as illustrated in the drawings. Spatially relative terms are intended to encompass different orientations of an apparatus in use, operation, and/or manufacture in addition to the orientation depicted in the drawings. For example, if the device in the drawings is turned upside down, elements described as "under" other elements or features would then be oriented "on" the other elements or features. Thus, the term "under" can encompass both an orientation of above and below. Furthermore, the device may be otherwise oriented (e.g., rotated 90 degrees or at other orientations), and, as such, the spatially relative descriptors used herein interpreted accordingly.

Various embodiments will be described with reference to diagrams illustrating idealized embodiments. As such, variations from the shapes of the illustrations as a result, for example, of manufacturing techniques and/or tolerances, are to be expected. Therefore, embodiments disclosed herein should not be construed as limited to the particular illustrated shapes of regions, but are to include deviations in shapes that result from, for instance, manufacturing. As such, the shapes illustrated in the drawings may not illustrate the actual shapes of regions of a device, and, as such, are not intended to be limiting.

Hereinafter, the disclosure will be described in detail with reference to the accompanying drawings.

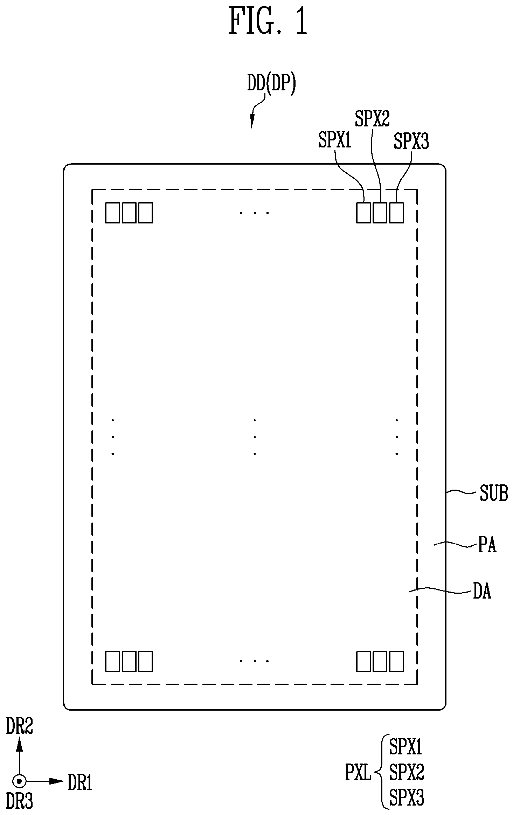

FIG. 1 is a schematic plan view illustrating a display device DD in accordance with embodiments.

Referring to FIG. 1, a display panel DP (or the display device DD) in accordance with an embodiment may be provided in various forms, for example, in the form of a rectangular plate having two pairs of parallel sides, but embodiments are not limited thereto. In the case where the display panel DP is provided in the form of a rectangular plate, a pair of sides of the two pairs of sides may be provided longer than the other pair of sides.

At least a portion of the display panel DP may have flexibility, and the display panel DP may be folded at the portion having the flexibility, but embodiments are not limited thereto.

The display panel DP may display an image. A self-emissive display panel, such as an organic light emitting display (OLED) panel including an organic light emitting diode as a light emitting element, a subminiature light emitting diode (micro-LED or nano-LED) display panel including a subminiature LED as a light emitting element, and a quantum dot organic light emitting display (QD OLED) panel including a quantum dot and an organic light emitting diode, may be used as the display panel DP. For example, a non-emissive display panel such as a liquid crystal display (LCD) panel, an electro-phoretic display (EPD) panel, or an electro-wetting display (EWD) panel may be used as the display panel DP. In case that the non-emissive display panel is used as the display panel DP, the display device DD may include a backlight unit that supplies light to the display panel DP.

The display panel DP may include a substrate SUB and pixels PXL provided (or disposed) on the substrate SUB.

The substrate SUB may include a transparent insulating material that transmits light. The substrate SUB may be a rigid substrate or a flexible substrate. For example, the rigid substrate may be one of a glass substrate, a quartz substrate, a glass ceramic substrate, and a crystalline glass substrate.

The flexible substrate may be either a film substrate or a plastic substrate which includes a polymer organic material. For example, the flexible substrate may include at least one of polystyrene, polyvinyl alcohol, polymethyl methacrylate, polyethersulfone, polyacrylate, polyetherimide, polyethylene naphthalate, polyethylene terephthalate, polyphenylene sulfide, polyarylate, polyimide, polycarbonate, triacetate cellulose, and cellulose acetate propionate.

The display device DD may have various shapes. For example, the display device DD may be provided in the form of a rectangular plate, but embodiments are not limited thereto. For instance, the display device DD may have a shape such as a circular shape or an elliptical shape. Furthermore, the display device DD may have an angled corner and/or curved corner. For convenience of explanation, FIG. 1 illustrates that the display device DD has a rectangular plate shape. For example, in FIG. 1, an extension direction (e.g., a horizontal direction) of a short side of the display device DD is designated as a first direction DR1, and an extension direction (e.g., a vertical direction) of a long side thereof is designated as a second direction DR2.

The substrate SUB (or the display device DD) may include a display area DA that displays an image, and a peripheral area PA (or a non-display area) formed in an area other than the display area DA. The substrate SUB may include a display area DA including pixel areas in which the respective pixels PXL are disposed, and a peripheral area PA disposed around the perimeter of the display area DA (or adjacent to the display area DA).

The peripheral area PA may be disposed adjacent to the display area DA. The peripheral area PA may be provided (or disposed) on at least one side of the display area DA. For example, the peripheral area PA may enclose the perimeter (or edge portions) of the display area DA. In an embodiment, the peripheral area PA may be a bezel area of the display device DD.

The pixels PXL may be disposed in the display area DA on the substrate SUB. The peripheral area PA may be disposed around the display area DA. A structure for protecting components included in the pixels PXL disposed in the display are DA may be provided in the peripheral area PA, but embodiments are not limited thereto. For example, in the peripheral area PA, there may be a line component connected to the respective pixels PXL, and a driver connected to the line component. The driver may drive the pixels PXL.

Each of the pixels PXL may include sub-pixels SPX1, SPX2, and SPX3. For example, the pixel PXL may include a first sub-pixel SPX1, a second sub-pixel SPX2, and a third sub-pixel SPX3. The first sub-pixel SPX1, the second sub-pixel SPX2, and the third sub-pixel SPX3 may be successively arranged in the first direction DR1. However, embodiments are not limited to the foregoing description, and the first sub-pixel SPX1, the second sub-pixel SPX2, and the third sub-pixel SPX3 may be successively disposed in the second direction DR2 intersecting the first direction DR1.

The first, second, and third sub-pixels SPX1, SPX2, and SPX3 may emit different colors of light. For instance, the first sub-pixel SPX1 may be a red sub-pixel that emits red light, the second sub-pixel SPX2 may be a green sub-pixel that emits green light, and the third sub-pixel SPX3 may be a blue sub-pixel that emits blue light. However, the colors, types and/or number of pixels forming the pixel PXL are not limited thereto. For example, the color of light which is emitted from each of the first, second, and third sub-pixels SPX1, SPX2, and SPX3 may be changed in various ways. Hereinafter, the term "pixel PXL" will be used to collectively designate the first, second, and third sub-pixels SPX1, SPX2, and SPX3.

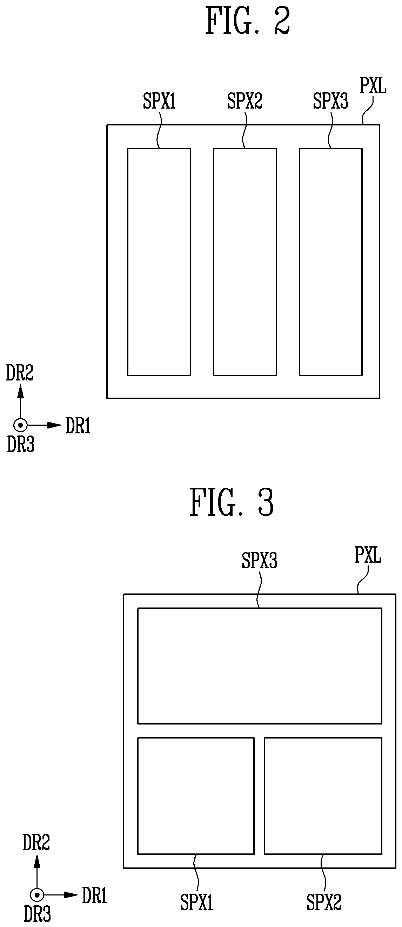

FIGS. 2 to 4 are schematic plan views illustrating embodiments of the pixel of FIG. 1.

Referring to FIGS. 1 to 4, the pixel PXL may include sub-pixels SPX1, SPX2, and SPX3. Although FIGS. 2 to 4 illustrate that each of the pixels PXL includes a first sub-pixel SPX1, a second sub-pixel SPX2, and a third sub-pixel SPX3, embodiments are not limited thereto.

The first sub-pixel SPX1, the second sub-pixel SPX2, and the third sub-pixel SPX3 may be connected to at least one data line among the data lines and at least one scan line among the scan lines.

Referring to FIGS. 2 to 4, each of the first sub-pixel SPX1, the second sub-pixel SPX2, and the third sub-pixel SPX3 may have a rectangular, square, or polygonal planar shape.

Referring to FIG. 2, each of the first sub-pixel SPX1, the second sub-pixel SPX2, and the third sub-pixel SPX3 may have a rectangular planar shape having short sides extending in the first direction DR1 and long sides extending in the second direction DR2. However, embodiments are not limited to the aforementioned example. In an embodiment, each of the first sub-pixel SPX1, the second sub-pixel SPX2, and the third sub-pixel SPX3 may have a square or rhombus planar shape having sides having the same length in the first direction DR1 and the second direction DR2. In an embodiment, the first sub-pixel SPX1, the second sub-pixel SPX2, and the third sub-pixel SPX3 may be arranged in the first direction DR1. In an embodiment, the first, second, and third sub-pixels SPX1, SPX2, and SPX3 may have the same surface area (or same size), but embodiments are not limited thereto. For example, the surface area (or size) of at least one of the first, second, and third sub-pixels SPX1, SPX2, and SPX3 may differ from that of another one. In another example, any two of the surface area (or size) of the first sub-pixel SPX1, the surface area (or size) of the second sub-pixel SPX2, and the surface area (or size) of the third sub-pixel SPX3 may be substantially the same as each other, and a remaining one may be different from the two. In another example, the surface area (or size) of the first sub-pixel SPX1, the surface area (or size) of the second sub-pixel SPX2, and the surface area (or size) of the third sub-pixel SPX3 may be different from each other.

Referring to FIG. 3, the first sub-pixel SPX1 may be arranged with one of the second sub-pixel SPX2 and the third sub-pixel SPX3 in a first direction DR1, and may be arranged with a remaining one of the second sub-pixel SPX2 and the third sub-pixel SPX3 in a second direction DR2. For example, the first sub-pixel SPX1 may be arranged parallel to the second sub-pixel SPX2 in the first direction DR1. The first sub-pixel SPX1 may be arranged parallel to the third sub-pixel SPX3 in the second direction DR2. In an embodiment, the third sub-pixel SPX3 may be positioned in the second direction DR2 with respect to the first sub-pixel SPX1 and the second sub-pixel SPX2. In an embodiment, the surface areas (or sizes) of the first and second sub-pixels SPX1 and SPX2 may be substantially the same as each other. The surface area (or size) of the third sub-pixel SPX3 may differ from the surface areas of the first and second sub-pixels SPX1 and SPX2. For example, the surface area (or size) of the third sub-pixel SPX3 may be greater than the surface area (or size) of each of the first and second sub-pixels SPX1 and SPX2.

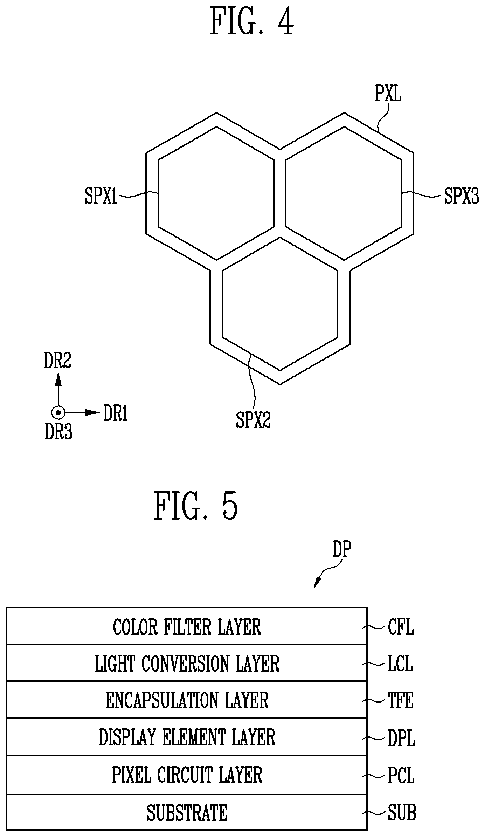

Referring to FIG. 4, each of the first sub-pixel SPX1, the second sub-pixel SPX2, and the third sub-pixel SPX3 may have a hexagonal or regular hexagonal planar shape. In an embodiment, two adjacent sides of six sides of each of the first, second, and third sub-pixels SPX1, SPX2, and SPX3 may face corresponding sides of adjacent sub-pixels.

Referring to FIG. 2 to 4, the first sub-pixel SPX1 may emit first light. The second sub-pixel SPX2 may emit second light. The third sub-pixel SPX3 may emit third light. The first color may be light in a red wavelength band. The second color may be light in a green wavelength band. The third color may be light in a blue wavelength band. The red wavelength band may be a wavelength band ranging from about 600 nm to about 750 nm. The green wavelength band may be a wavelength band ranging from about 480 nm to about 560 nm. The blue wavelength band may be a wavelength band ranging from about 370 nm to about 460 nm. However, embodiments are not limited thereto.

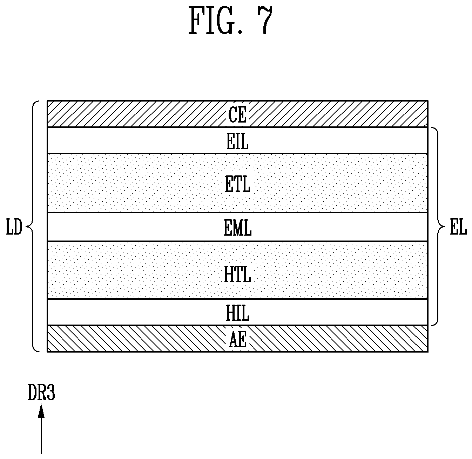

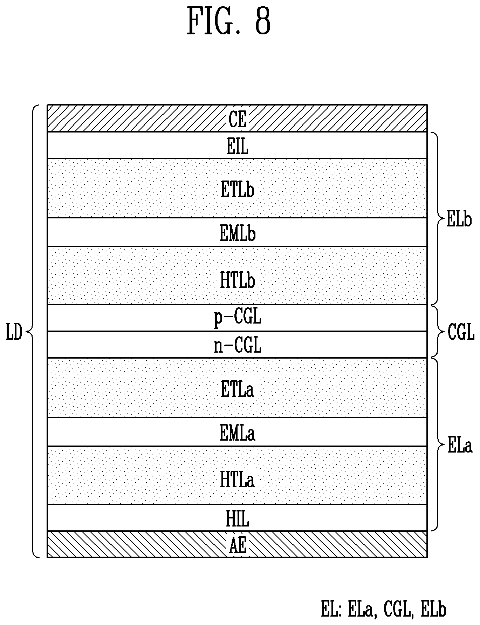

Each of the first sub-pixel SPX1, the second sub-pixel SPX2, and the third sub-pixel SPX3 may be a light emitting element (e.g., a light emitting element LD of FIGS. 7 and 8) that emits light. The light emitting element may include an organic light emitting element having an organic layer.

FIG. 5 is a schematic sectional view illustrating a display panel of FIG. 1.

Referring to FIG. 5, the display panel DP may include a substrate SUB, a pixel circuit layer PCL, a display element layer DPL, an encapsulation layer TFE, a light conversion layer LCL, and a color filter layer CFL. In an embodiment, the substrate SUB, the pixel circuit layer PCL, the display element layer DPL, the encapsulation layer TFE, the light conversion layer LCL, and the color filter layer CFL may be sequentially stacked in the third direction DR3.

The pixel circuit layer PCL may be provided (or disposed) on the substrate SUB, and include transistors and signal lines connected to the transistors. For example, each transistor may have a shape in which a semiconductor pattern, a gate electrode, a source electrode, and a drain electrode are successively stacked with insulating layers interposed therebetween. The semiconductor pattern may include amorphous silicon, poly silicon, low temperature poly silicon, and an organic semiconductor, and/or an oxide semiconductor. Although the gate electrode, the source electrode, and the drain electrode each may include one of aluminum (Al), copper (Cu), titanium (Ti), and molybdenum (Mo), embodiments are not limited thereto. For example, the pixel circuit layer PCL may include at least one or more insulating layers.

The display element layer DPL may be disposed on the pixel circuit layer PCL. The display element layer DPL may include a light emitting element (e.g., a light emitting element LD of FIG. 7 or 8) that emits light. Although the light emitting element may be, e.g., an organic light emitting diode, embodiments are not limited thereto. In an embodiment, the light emitting element may be an inorganic light emitting element including an inorganic light emitting material, or a light emitting element that emits light generated by changing (or converting) the wavelength of the light using quantum dots.

The encapsulation layer TFE may be disposed on the display element layer DPL. The encapsulation layer TFE may be an encapsulation substrate or may have the form of an encapsulation film having a multilayer structure. In case that the encapsulation layer TFE has the form of the encapsulation film, the encapsulation layer TFE may include an inorganic layer and/or an organic layer. For example, the encapsulation layer TFE may have a structure formed by successively stacking an inorganic layer, an organic layer, and an inorganic layer. The encapsulation layer TFE may prevent external air or water from permeating the display element layer DPL or the pixel circuit layer PCL.

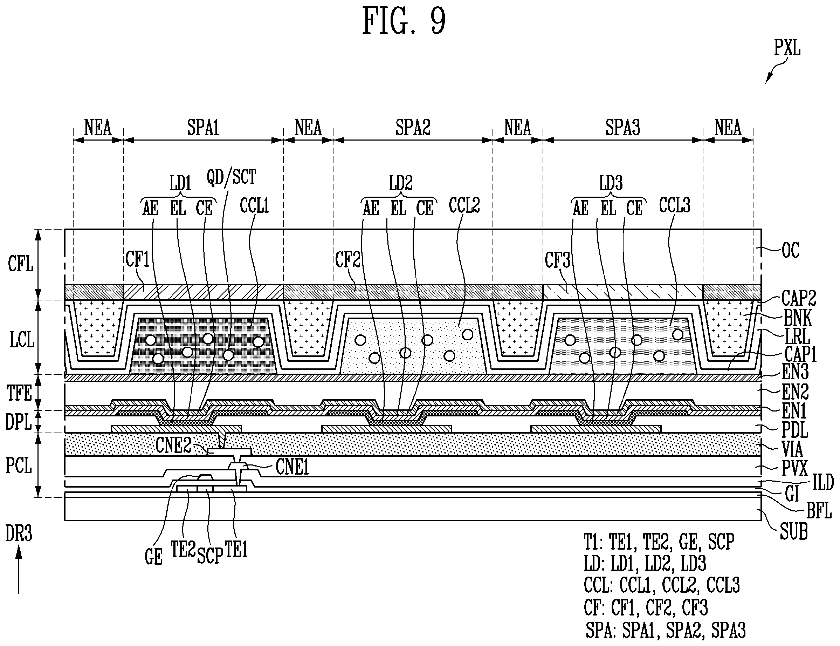

The light conversion layer LCL may be disposed on the encapsulation layer TFE. The light conversion layer LCL may convert light emitted from the display element layer DPL to a certain color of light, and may include elements for enhancing the light output efficiency. In an embodiment, the light conversion layer LCL may include a color conversion layer (e.g., a color conversion layer CCL of FIG. 9), and a low refractive layer (e.g., a low refractive layer LRL of FIG. 9).

The color filter layer CFL may be disposed on the light conversion layer LCL. The color filter layer CFL may selectively transmit light passing through the light conversion layer LCL (or the display element layer DPL). The color filter layer CFL may include first, second, and third color filters (e.g., first, second, and third color filters CF1, CF2, and CF3 of FIG. 9).

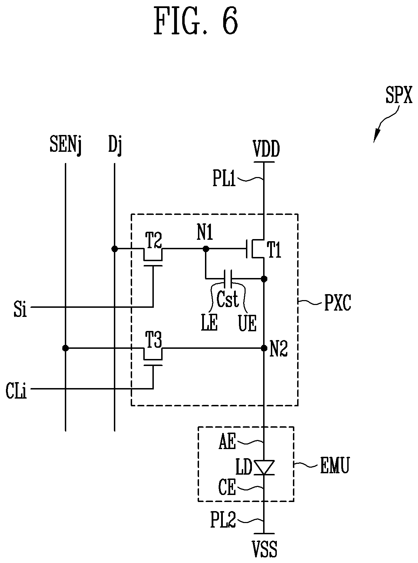

FIG. 6 is a schematic diagram of an equivalent circuit of an embodiment of a sub-pixel included in the pixel of FIGS. 2 to 4.

A sub-pixel SPX illustrated in FIG. 6 may be any one of the sub-pixels SPX1, SPX2, and SPX3 illustrated in FIG. 1. The sub-pixels SPX1, SPX2, and SPX3 arranged in the display area of the display device DD may have a substantially identical or similar configuration.

For the sake of explanation, FIG. 6 illustrates a sub-pixel SPX positioned on an i-th pixel row (or an i-th horizontal line) and a j-th pixel column (where each of i and j is a positive integer).

Referring to FIG. 6, the sub-pixel SPX may include an emission component EMU that generates light having a luminance corresponding to a data signal. Furthermore, the sub-pixel SPX may further include a pixel circuit PXC that drives the emission component EMU.

The emission component EMU may include a light emitting element LD connected between a first power line PL1, which receives a voltage from a first driving power supply VDD (or a first power supply), and a second power line PL2, which receives a voltage from a second driving power supply VSS (or a second power supply). For example, the emission component EMU may include a light emitting element LD which include a first pixel electrode AE connected to the first driving power supply VDD via the pixel circuit PXC and the first power line PL1, and a second pixel electrode CE connected to the second driving power supply VSS via the second power line PL2. The first pixel electrode AE may be an anode, and the second pixel electrode CE may be a cathode. The first driving power supply VDD and the second driving power supply VSS may have different potentials. For example, a difference in potential between the first and second driving power supplies VDD and VSS may be set to a value equal to or greater than a threshold voltage of the light emitting elements LD during an emission period of the sub-pixel SPX.

In the case in which the sub-pixel SPX is disposed on an i-th pixel row and a j-th pixel column in the display area DA, the pixel circuit PXC of the sub-pixel SPX may be electrically connected to an i-th scan line Si and a j-th data line Dj. Furthermore, the pixel circuit PXC may be electrically connected to an i-th control line CLi and a j-th sensing line SENj.

The pixel circuit PXC may include first, second, and third transistors T1, T2, and T3, and a storage capacitor Cst.

The first transistor T1 may be electrically connected between the first driving power supply VDD and the light emitting element LD as a driving transistor to control driving current to be applied to the light emitting element LD. For example, a first terminal of the first transistor T1 may be electrically connected to the first driving power supply VDD by the first power line PL1. A second terminal of the first transistor T1 may be electrically connected to a second node N2. A gate electrode of the first transistor T1 may be electrically connected to a first node N1. The first transistor T1 may control, in response to a voltage applied to the first node N1, driving current to be applied from the first driving power supply VDD to the light emitting element LD through the second node N2. In an embodiment, the first terminal of the first transistor T1 may be a drain electrode, and the second terminal of the first transistor T1 may be a source electrode. However, embodiments are not limited thereto. In an embodiment, the first terminal may be a source electrode, and the second terminal may be a drain electrode.

The second transistor T2 may be electrically connected between the data line Dj (e.g., the j-th data line) and the first node N1, and may function as a switching transistor to select a sub-pixel SPX in response to a scan signal and activate the sub-pixel SPX. A first terminal of the second transistor T2 may be electrically connected to the data line Dj. A second terminal of the second transistor T2 may be electrically connected to the first node N1 (or the gate electrode of the first transistor T1). A gate electrode of the second transistor T2 may be electrically connected to the scan line Si (or the i-th scan line). The first terminal and the second terminal of the second transistor T2 may be different terminals. For example, in case that the first terminal is a drain electrode, the second terminal may be a source electrode.

In case that a scan signal having a gate-on voltage (e.g., a high level voltage) is supplied from the scan line Si, the second transistor T2 may be turned on to electrically connect the data line Dj to the first node N1. The first node N1 may be a point at which the second terminal of the second transistor T2 and the gate electrode of the first transistor T1 are connected to each other. The second transistor T2 may transmit a data signal to the gate electrode of the first transistor T1.

The third transistor T3 may acquire (or obtain) a sensing signal through the sensing line SENj by electrically connecting the first transistor T1 to the sensing line SENj (e.g., the j-th sensing line), and detect (or measure), using the sensing signal, characteristics of the sub-pixel SPX such as a threshold voltage of the first transistor T1. Information about the characteristics of each sub-pixel SPX may be used to convert image data, thereby compensating for a deviation in characteristic between sub-pixels SPX. A second terminal of the third transistor T3 may be electrically connected to the second terminal of the first transistor T1. A first terminal of the third transistor T3 may be electrically connected to the sensing line SENj. A gate electrode of the third transistor T3 may be electrically connected to the control line CLi (e.g., the i-th control line). The first terminal may be a drain electrode, and the second terminal may be a source electrode.

The third transistor T3 may be an initialization transistor that initializes the second node N2, and may be turned on in case that a sensing control signal is supplied thereto from the control line CLi, thereby applying the voltage of the initialization power supply to the second node N2. Hence, the storage capacitor Cst which is electrically connected to the second node N2 may be initialized.

The storage capacitor Cst may include a lower electrode LE (or a first storage electrode) and an upper electrode UE (or a second storage electrode). The lower electrode LE may be electrically connected to the first node N1. The upper electrode UE may be electrically connected to the second node N2. The storage capacitor Cst may be charged with a data voltage corresponding to a data signal to be supplied to the first node N1 during one frame period. Hence, the storage capacitor Cst may store a voltage corresponding to a difference between a voltage of the gate electrode of the first transistor T1 and a voltage of the second node N2.

Although FIG. 6 illustrates an embodiment where all of the first, second, and third transistors T1, T2, and T3 are N-type transistors, embodiments are not limited thereto. For example, at least one of the first, second, and third transistors T1, T2, and T3 may be changed (or modified) to a P-type transistor. The structure of the pixel circuit PXC may be changed (or modified) in various ways.

In the following embodiments, for convenience of explanation, a transverse direction (or an X-axis direction or a horizontal direction) in a plan view will be indicated by a first direction DR1, a longitudinal direction (or an Y-axis direction or a vertical direction) in a plan view will be indicated by a second direction DR2, and a vertical direction in a sectional view will be indicated by a third direction DR3.

FIG. 7 is a schematic sectional view illustrating an embodiment of the light emitting element LD of FIG. 6. FIG. 8 is a schematic sectional view illustrating another embodiment of the light emitting element LD of FIG. 6.

Referring to FIG. 7, the light emitting element LD may include a first pixel electrode AE, an organic emission component EL, and a second pixel electrode CE that are sequentially stacked.

In an embodiment, the first pixel electrode AE may be patterned to correspond to first, second, and third sub-pixels (e.g., the first, second, and third sub-pixels SPX1, SPX2, and SPX3).

In an embodiment, the organic emission component EL may be provided (or disposed) on the first pixel electrode AE. The organic emission component EL may have a multilayer thin-film structure including light generation layers. The organic emission component EL may include a hole injection layer HIL, a hole transport layer HTL, an emission layer EML, an electron transport layer ETL, and an electron injection layer EIL that are sequentially stacked.

The hole injection layer HIL may be an organic layer that is disposed between the first pixel electrode AE and the hole transport layer HTL to facilitate injection of holes from the first pixel electrode AE to the emission layer EML. The hole transport layer HTL may be disposed between the hole injection layer HIL and the first pixel electrode AE to receive holes from the first pixel electrode AE and to transport the holes to the emission layer EML.

The electron injection layer EIL may be disposed between the electron transport layer ETL and the second pixel electrode CE. The electron transport layer ETL may be disposed on the emission layer EML and may receive electrons from the second pixel electrode CE and transmit the electrons to the emission layer EML.

The emission layer EML may be an area where light is generated by combination of electrons and holes that are supplied from the first pixel electrode AE and the second pixel electrode CE. The emission layer EML may include an organic light-emitting material such as a high-molecular organic material or a low-molecular organic material, which emits a certain color of light. For example, the emission layer EML may be formed of an organic material that emits blue light. However, embodiments are not limited thereto. In an embodiment, the emission layer EML may be formed of an organic material that emits red or green light, or may be formed of inorganic material or quantum dots.

In an embodiment, the second pixel electrode CE may be integrally provided (or formed) as a body. The second pixel electrode CE may be disposed on the organic emission component EL. The second pixel electrode CE may be integral with light emitting elements.

Referring to FIG. 8, the light emitting element LD may include a first pixel electrode AE, an organic emission component EL, and a second pixel electrode CE.

The organic emission component EL may include light generation layers. In an embodiment, the organic emission component EL may include a first organic emission component ELa, a charge generation layer CGL, and a second organic emission component ELb. The first pixel electrode AE, the first organic emission component ELa, the charge generation layer CGL, the second organic emission component ELb, and the second pixel electrode CE may be sequentially stacked.

The first organic emission component ELa may have a structure in which a hole injection layer HIL, a first hole transport layer HTLa, a first organic emission layer EMLa, and a first electron transport layer ETLa that are sequentially stacked. The second organic emission component ELb may include a structure in which a second hole transport layer HTLb, a second organic emission layer EMLb, a second electron transport layer ETLb, and an electron injection layer EIL that are sequentially stacked.

In an embodiment, a buffer layer (not shown) may be disposed on the first organic emission layer EMLa and the second organic emission layer EMLb. The buffer layer may include an electron transport compound.

The charge generation layer CGL may supply charges to the first organic emission component ELa and the second organic emission component ELb. The charge generation layer CGL may include an n-type charge generation layer n-CGL that supplies charges (or electrons) to the first organic emission component ELa, and a p-type charge generation layer p-CGL that supplies holes to the second organic emission component ELb. The n-type charge generation layer n-CGL may include a metal material as a dopant.

Although FIG. 8 illustrates that two organic emission components ELa and ELb are stacked and provided in the light emitting element LD, embodiments are not limited thereto. For example, three, four, or more organic emission components may be stacked and provided in the light emitting element LD.

FIG. 9 is a schematic sectional view illustrating an embodiment of a pixel including the light emitting element LD of FIG. 7 or 8.

Referring to FIGS. 1 and 9, the display device DD may include a display area DA. The display area DA may include first, second, and third sub-pixel areas SPA1, SPA2, and SPA3 and a non-emission area NEA. In an embodiment, the first sub-pixel area SPA1 may be an area of the first sub-pixel SPX1 from which light in a first color is emitted. The second sub-pixel area SPA2 may be an area of the second sub-pixel SPX2 from which light in a second color is emitted. The third sub-pixel area SPA3 may be an area of the third sub-pixel SPX3 from which light in a third color is emitted. In an embodiment, emission areas of the display area DA may correspond to the first, second, and third sub-pixel areas SPA1, SPA2, and SPA3. The first, second, and third sub-pixel areas SPA1, SPA2, and SPA3 and the non-emission area NEA may be defined by a bank BNK of the light conversion layer LCL.

Referring to FIG. 9, although there is illustrated an embodiment where the first, second, and third sub-pixel areas SPA1, SPA2, and SPA3 are adjacent to each other in a direction intersecting with the third direction DR3, embodiments are not limited thereto.

In an embodiment, the pixel PXL may include the pixel circuit layer PCL, the display element layer DPL, the encapsulation layer TFE, the light conversion layer LCL, and the color filter layer CFL that are sequentially disposed on the substrate SUB in the third direction DR3.

In the pixel circuit layer PCL, there may be disposed circuit elements (e.g., the first, second, and third transistors T1, T2, and T3 of FIG. 6), and signal lines that are electrically connected to the circuit elements. The pixel circuit layer PCL may be disposed on the substrate SUB. The pixel circuit layer PCL may include a first transistor T1, a buffer layer BFL, a gate insulating layer GI, an interlayer insulating layer ILD, a passivation layer PVX, and a via layer VIA. As an example, although one transistor T1 is illustrated, the sub-pixel SPX may include transistors and at least one capacitor to drive the light emitting element LD.

A buffer layer BFL may be disposed on the substrate SUB. The buffer layer BFL may prevent impurities from diffusing from the outside. The buffer layer BFL may prevent impurities from being diffused into the first transistor T1 provided (or disposed) on the substrate SUB, and may enhance planarization of the substrate SUB. The buffer layer BFL may be provided (or formed) in the form of a single-layer structure, or provided in the form of a multilayer structure. The buffer layer BFL may be an inorganic insulating layer including an inorganic material. The inorganic insulating layer may include, for example, at least one of silicon nitride (SiNₓ), silicon oxide (SiOₓ), silicon oxynitride (SiOₓN_{y}), and metal oxide such as aluminum oxide (AlOₓ). In the case where the buffer layer BFL is provided in the form of a multilayer structure, the respective layers may be formed of the same material or different materials. The buffer layer BFL may be omitted in some cases.

The first transistor T1 may include a semiconductor pattern SCP, a gate electrode GE, a first terminal TE1, and a second terminal TE2. The first terminal TE1 may be one of a source electrode and a drain electrode, and the second terminal TE2 may be another one of the source electrode and the drain electrode. For example, in the case in which the first terminal TE1 is a drain electrode, the second terminal TE2 may be a source electrode.

The semiconductor pattern SCP may be provided and/or formed on the buffer layer BFL. The semiconductor pattern SCP may include a first area that contacts the first terminal TE1, a second area that contacts the second terminal TE2, and a channel area formed between the first area and the second area. The channel area may overlap the gate electrode GE of the first transistor T1. The semiconductor pattern SCP may be a semiconductor pattern formed of amorphous silicon, polysilicon, low-temperature polysilicon, an oxide semiconductor, an organic semiconductor, or the like. For example, the channel area may be an undoped semiconductor pattern, and may be an intrinsic semiconductor. Each of the first area and the second area may be a semiconductor pattern doped with impurities. In an embodiment, the first terminal TE1 may be electrically connected to the light emitting element LD through connection electrodes CNE1 and CNE2.

The gate insulating layer GI may be provided and/or formed on the semiconductor pattern SCP. The gate insulating layer GI may be an inorganic insulating layer including an inorganic material. The gate insulating layer GI may include one or more materials selected from among the materials as the constituent materials of the buffer layer BFL. For example, the gate insulating layer GI and the buffer layer BFL may include the same material. For example, the gate insulating layer GI may be formed of an organic insulating layer including an organic material. Although the gate insulating layer GI may be provided in a single-layer structure, the gate insulating layer GI may be provided in a multilayer structure having at least two or more layers.

The gate electrode GE may be provided and/or formed on the gate insulating layer GI to correspond to (or to overlap) the channel area of the semiconductor pattern SCP. The gate electrode GE may be provided (or disposed) on the gate insulating layer GI and overlap the channel area of the semiconductor pattern SCP. The gate electrode GE may have a single layer structure formed of one or combination selected from the group consisting of copper (Cu), molybdenum (Mo), tungsten (W), aluminum neodymium (AlNd), titanium (Ti), aluminum (Al), silver (Ag), and an alloy thereof, or may have a double layer or multilayer structure formed of molybdenum (Mo), titanium (Ti), copper (Cu), aluminum (Al), or silver (Ag) to reduce line resistance.

The interlayer insulating layer ILD may be provided and/or formed on the gate electrode GE. The first connection electrode CNE1 may be disposed on the interlayer insulating layer ILD. The first connection electrode CNE1 may be electrically connected to the first terminal TE1 through a contact hole that passes through the gate insulating layer GI and the interlayer insulating layer ILD.

The passivation layer PVX may be provided and/or formed on the first connection electrode CNE1. The second connection electrode CNE2 may be disposed on the passivation layer PVX. The second connection electrode CNE2 may be electrically connected to the first connection electrode CNE1 through a contact hole that passes through the passivation layer PVX.

The passivation layer PVX may be provided in the form of a structure including an inorganic insulating layer disposed on an organic insulating layer, or a structure including an organic insulating layer disposed on an inorganic insulating layer. The inorganic insulating layer may include, for example, at least one of silicon oxide (SiOₓ), silicon nitride (SiNₓ), silicon oxynitride (SiOₓN_{y}), and metal oxide such as aluminum oxide (AlOₓ). The organic insulating layer may include, for example, at least one of polyacrylate resin, epoxy resin, phenolic resin, polyamide resin, polyimide rein, unsaturated polyesters resin, poly-phenylen ethers resin, polyphenylene sulfide resin, and benzocyclobutene resin.

The via layer VIA may be provided and/or formed on the overall surface of the passivation layer PVX. The via layer VIA may be an inorganic insulating layer including an inorganic material or an organic insulating layer including an organic material.

The display element layer DPL may be disposed on the via layer VIA. The display element layer DPL may include the light emitting element LD and a pixel defining layer PDL. The light emitting element LD and the pixel defining layer PDL may be provided and/or formed on the via layer VIA. The light emitting element LD may include a first light emitting element LD1 disposed in the first sub-pixel area SPA1, a second light emitting element LD2 disposed in the second sub-pixel area SPA2, and a third light emitting element LD3 disposed in the third sub-pixel area SPA3.

Each of the light emitting elements LD may include a first pixel electrode AE, an emission layer EML, and a second pixel electrode CE. The light emitting element LD may be electrically connected to a pixel circuit (e.g., the pixel circuit PXC of FIG. 6) of the corresponding pixel.

The first pixel electrode AE may be provided and/or formed on the via layer VIA of the corresponding pixel. The first pixel electrode AE may be an anode electrode of the light emitting element LD. The first pixel electrode AE may be electrically connected to the first terminal TE1 through a corresponding contactor. In an embodiment, the first pixel electrode AE may include anode electrodes corresponding to the first, second, and third sub-pixel areas SPA1, SPA2, and SPA3. The first pixel electrode AE may be patterned to correspond to (or to overlap) the first, second, and third sub-pixel areas SPA1, SPA2, and SPA3.

The first pixel electrode AE may be formed of a conductive material (or substance). The conductive material may include opaque metal. For example, the opaque metal may include metal such as silver (Ag), magnesium (Mg), aluminum (Al), platinum (Pt), palladium (Pd), gold (Au), nickel (Ni), neodymium (Nd), iridium (Ir), chrome (Cr), titanium (Ti), and an alloy thereof. However, the material of the first pixel electrode AE is not limited to the foregoing embodiment. In an embodiment, the first pixel electrode AE may include a transparent conductive material (or substance). The transparent conductive material (or substance) may include transparent conductive oxides such as indium tin oxide (ITO), indium zinc oxide (IZO), zinc oxide (ZnOₓ), indium gallium zinc oxide (IGZO), and indium tin zinc oxide (ITZO), and a conductive polymer such as poly(3,4-ethylenedioxythiophene) (PEDOT). In the case in which the first pixel electrode AE includes a transparent conductive material (or substance), there may be provided a separate conductive layer made of opaque metal to reflect light emitted from the emission layer EML in an image display direction (or in a direction toward the encapsulation layer TFE) of the display device (e.g., the display device DD of FIG. 1).

The pixel defining layer PDL may define (or partition) an area where the organic emission component EL is disposed. The pixel defining layer PDL may be an organic insulating layer made of an organic material. In an embodiment, the pixel defining layer PDL may include a light absorbing material or be coated with light absorbent, so that the pixel defining layer PDL may absorb light introduced from the outside. For example, the pixel defining layer PDL may include carbon-based black pigment. Embodiments are not limited thereto.

The pixel defining layer PDL may be partially open to include an opening through which an area of the first pixel electrode AE is exposed. The pixel defining layer PDL may protrude from the via layer VIA in the third direction DR3 along the periphery of the emission area EMA. The pixel defining layer PDL may be disposed on the via layer VIA to define an area where the organic emission component EL is disposed and accommodated on the first pixel electrode AE. The organic emission component EL may be disposed on the first pixel electrode AE that is exposed through the opening of the pixel defining layer PDL.

The organic emission component EL may have a multilayer thin-film structure including a light generation layer that generates light. The organic emission component EL may emit one of red light, green light, and blue light, but embodiments are not limited thereto. For example, the organic emission component EL may include a white emission layer that emits white light. The internal design of the organic emission component EL may also vary according to a selected color of light to be produced.

The second pixel electrode CE may be disposed on the organic emission component EL and the pixel defining layer PDL. The second pixel electrode CE may be provided in the form of a plate in the overall area of the display area DA.

The second pixel electrode CE may be a thin metal layer having a thickness sufficient for enabling light emitted from the organic emission component EL to transmit therethrough. The second pixel electrode CE may be made of a metal material or a transparent conductive material and may have a relatively small thickness. The second pixel electrode CE may include at least one of various transparent conductive materials including indium tin oxide, indium zinc oxide, indium tin zinc oxide, aluminum zinc oxide, gallium zinc oxide, zinc tin oxide, or gallium tin oxide, and may be substantially transparent or translucent to provide satisfactory transmittance. Hence, light emitted from the organic emission component EL positioned under the second pixel electrode CE may be emitted in a direction toward an upper surface of the encapsulation layer TFE through the second pixel electrode CE.

The encapsulation layer TFE may be provided and/or formed on the overall surface of the second pixel electrode CE. The encapsulation layer TFE may include first, second, and third encapsulation layers EN1, EN2, and EN3 which are sequentially positioned on the second pixel electrode CE. The first encapsulation layer EN1 and the third encapsulation layer EN3 may be inorganic layers including an inorganic material. The second encapsulation layer EN2 may be an organic layer including an organic material. The first encapsulation layer EN1 and the third encapsulation layer EN3 may protect the sub-pixel SPX from water and oxygen. The second encapsulation layer EN2 may protect the sub-pixel SPX from foreign substances such as dust particles.

The light conversion layer LCL may be disposed on the encapsulation layer TFE. In an embodiment, the light conversion layer LCL may be disposed on the third encapsulation layer EN3 of the encapsulation layer TFE. The light conversion layer LCL may include the bank BNK, a first capping layer CAP1 (or a second layer of the light conversion layer LCL), a color conversion layer CCL (or a first layer of the light conversion layer LCL), a low refractive layer LRL, and a second capping layer CAP2 (or a third layer of the light conversion layer LCL).

The color conversion layer CCL may be disposed in an area overlapping the first, second, and third sub-pixel areas SPA1, SPA2, and SPA3. The color conversion layer CCL may include first, second, and third color conversion layers CCL1, CCL2, and CCL3 that respectively correspond to (or overlap) the first, second, and third sub-pixel areas SPA1, SPA2, and SPA3. The first color conversion layer CCL1 may be disposed in the first sub-pixel area SPA1. The second color conversion layer CCL2 may be disposed in the second sub-pixel area SPA2. The third color conversion layer CCL3 may be disposed in the third sub-pixel area SPA3.

The color conversion layer CCL may include color conversion particles, wavelength conversion particles, or quantum dot particles QD. For example, the color conversion particles QD may convert a first color of light (or light in a first wavelength band), which is incident thereon from the light emitting element LD, to a second color of light (or a specific color of light, or light in a second wavelength band), and emit the converted light. For example, the color conversion layer CCL may be formed by a photolithography process. For example, the method of forming the color conversion layer in accordance with embodiments are not limited thereto.

In an embodiment, the first, second, and third sub-pixel areas SPA1, SPA2, and SPA3 may include first, second, and third light emitting elements LD1, LD2, and LD3 that emit the same color of light. For example, the first, second, and third light emitting elements LD1, LD2, and LD3 may emit light in a third color (or blue light). The first, second, and third color conversion layers CCL1, CCL2, and CCL3 including color conversion particles are respectively disposed on the first, second, and third sub-pixel areas SPA1, SPA2, and SPA3, so that a full-color image may be displayed.

The first color conversion layer CCL1 may include first color conversion particles for converting the third color of light emitted from the first light emitting element LD1 to the first color of light (or red light). For example, the first color conversion layer CCL1 may include first quantum dot particles QD which are dispersed in a matrix material such as base resin. The first quantum dot particles QD of the first color conversion layer CCL1 may absorb blue light and shift the wavelength thereof according to energy transition to emit red light.

The second color conversion layer CCL2 may include second color conversion particles for converting the third color of light emitted from the second light emitting element LD2 to the second color of light (or green light). For example, the second color conversion layer CCL2 may include second quantum dot particles QD which are dispersed in a matrix material such as base resin. The second quantum dot particles QD of the second color conversion layer CCL2 may absorb blue light and shift the wavelength thereof according to energy transition to emit green light.

The third color conversion layer CCL3 may be provided to efficiently use third-color light (or blue light) emitted from the third light emitting element LD3. For example, in the case where the third light emitting element LD3 is a blue light emitting element that emits blue light and the third sub-pixel area SPA3 is a blue sub-pixel area, the third color conversion layer CCL3 may include at least one type of scatterer SCT to efficiently use light emitted from the third light emitting element LD3.

The first capping layer CAP1 may cover the color conversion layer CCL. For example, the first capping layer CAP1 may be disposed on the overall surface of the color conversion layer CCL. The first capping layer CAP1 may prevent water or foreign substances from penetrating into the color conversion layer CCL. The first capping layer CAP1 may include an inorganic material.

In an embodiment, the low refractive layer LRL may be disposed on the first capping layer CPL1. The low refractive layer LRL may control the path of light emitted from the color conversion layer CCL (or the display element layer DPL) from below. For example, the low refractive layer LRL may change the path of light that is incident thereon to a direction perpendicular to the planarization layer OC. The low refractive layer LRL may include a polymer material and a silica-based material.

In an embodiment, the second capping layer CAP2 may cover the low refractive layer LRL. For example, the second capping layer CAP2 may be disposed on the low refractive layer LRL. The second capping layer CAP2 may prevent water or foreign substances from penetrating into the low refractive layer LRL. The second capping layer CAP2 may include an inorganic material.

The bank BNK may be disposed on the second capping layer CAP2. The bank BNK may be disposed between the first, second, and third sub-pixel areas SPA1, SPA2, and SPA2 (or the first, second, and third sub-pixels SPX1, SPX2, and SPX3 of FIG. 1) or in boundaries therebetween. For example, the bank BNK may define the boundaries between the color conversion layers CCL.

The bank BNK may define the first, second, and third sub-pixel areas SPA1, SPA2, and SPA3 and the non-emission area NEA. The first, second, and third sub-pixel areas SPA1, SPA2, and SPA3 may be areas corresponding to (or overlapping) areas between portions of the bank BNK. The non-emission area NEA may be an area corresponding to (or overlapping) the bank BNK.

In an embodiment, the non-emission area NEA may refer to an area in which the bank BNK is disposed. In a plan view, the bank BNK may enclose the first, second, and third sub-pixel areas SPA1, SPA2, and SPA3.

The bank BNK may include an organic material such as acrylic resin, epoxy resin, phenolic resin, polyamide resin, polyimide resin, polyester resin, polyphenylene sulfide resin, or benzocyclobutene (BCB). However, embodiments are not limited thereto. The bank BNK may include various inorganic materials including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), or titanium oxide (TiOₓ).

The bank BNK may include at least one light blocking and/or reflective material. Therefore, light leakage between adjacent sub-pixels may be prevented or blocked by the bank BNK. For example, the bank BNK may include a black pigment, but embodiments are not limited thereto.

The bank BNK may be used to define boundaries between the color conversion layers. Furthermore, the bank BNK may be used to define areas from which respective colors of light are emitted (e.g., the first, second, and third sub-pixel areas SPA1, SPA2, and SPA3). In the case where the areas from which respective colors of light are emitted (e.g., the first, second, and third sub-pixel areas SPA1, SPA2, and SPA3) are defined by a color filter CF, the color filter CF in the non-emission area NEA may only be used for light blocking purposes. However, since the bank BNK is used to define areas from which respective colors of light are emitted (e.g., the first, second, and third sub-pixel areas SPA1, SPA2, and SPA3), the degree of freedom in design of the color filter CF in the non-emission area NEA may be relatively enhanced. For example, one or two layers of color filters CF may be used in the non-emission area NEA.

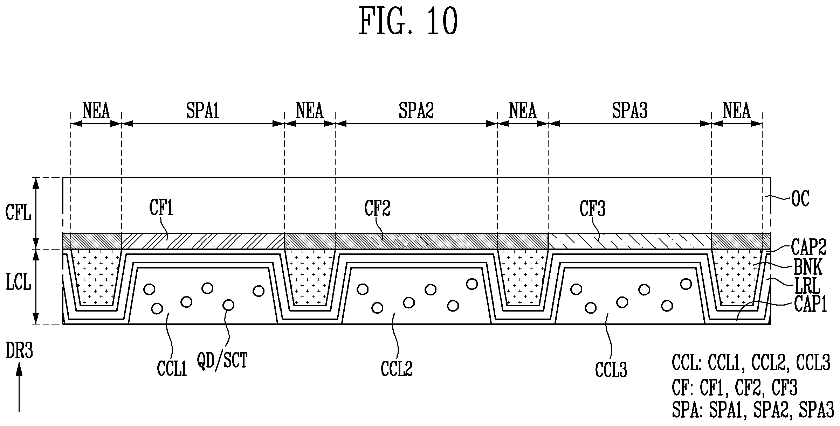

Detailed description of the color filter layer CFL will be provided with reference to FIG. 10 below.

FIG. 10 is a schematic sectional view illustrating the light conversion layer LCL and the color filter layer CFL of FIG. 9.

Referring to FIG. 10, the color filter layer CFL may be disposed on the light conversion layer LCL. In an embodiment, the color filter layer CFL may be disposed on the second capping layer CAP2 in the sub-pixel area SPA. The color filter layer CFL may be disposed on the bank BNK in the non-emission area NEA. The color filter layer CFL may include color filters CF and a planarization layer OC. The color filters CF may include first, second, and third color filters CF1, CF2, and CF3 respectively corresponding to the first, second, and third sub-pixel areas SPA1, SPA2, and SPA3. The color filters CF may contact the second capping layer CAP2 in the sub-pixel area SPA, and may be disposed on the second capping layer CAP2. For example, the first, second, and third color filters CF1, CF2, and CF3 may be formed by a photolithography process.

In an embodiment, the first color filter CF1, the second color filter CF2, and the third color filter CF3 may be respectively a red color filter, a green color filter, and a blue color filter, but embodiments are not limited thereto.

In an embodiment, the first color filter CF1 may be disposed on the second capping layer CAP2 to correspond to (or to overlap) the first sub-pixel area SPA1, and may selectively transmit light emitted from the first light emitting element LD1 and the first color conversion layer CCL1. In an embodiment, the first color filter CF1 may overlap the first color conversion layer CCL1 in the third direction DR3. The first color filter CF1 may include a color filter material for selectively passing the first color of light (or red light) therethrough. For example, in the case in which the first sub-pixel area SPA1 is a red sub-pixel area, the first color filter CF1 may include a red color filter material.

In an embodiment, the second color filter CF2 may be disposed on the second capping layer CAP2 to correspond to (or to overlap) the second sub-pixel area SPA2, and may selectively transmit light emitted from the second light emitting element LD2 and the second color conversion layer CCL2. In an embodiment, the second color filter CF2 may overlap the second color conversion layer CCL2 in the third direction DR3. The second color filter CF2 may include a color filter material for selectively passing the second color of light (or green light) therethrough. For example, in the case in which the second sub-pixel area SPA2 is a green sub-pixel area, the second color filter CF2 may include a green color filter material.

In an embodiment, the third color filter CF3 may be disposed on the second capping layer CAP2 to correspond to (or to overlap) the third sub-pixel area SPA3, and may selectively transmit light emitted from the third light emitting element LD3 and the third color conversion layer CCL3. In an embodiment, the third color filter CF3 may overlap the third color conversion layer CCL3 in the third direction DR3. The third color filter CF3 may include a color filter material for selectively passing the third color of light (or blue light) therethrough. For example, in the case in which the third sub-pixel area SPA3 is a blue sub-pixel area, the third color filter CF3 may include a blue color filter material.

In an embodiment, the planarization layer OC may be disposed on the first, second, and third color filters CF1, CF2, and CF3. The planarization layer OC may cover the first, second, and third color filters CF1, CF2, and CF3. The planarization layer OC is not limited as long as it is made of a material with excellent planarization characteristics and light transmittance, but the planarization layer OC may include an organic material or an inorganic material.

In an embodiment, the second color filter CF2 may be disposed in the non-emission area NEA. For example, the second color filter CF2 may be disposed on the bank BNK in the non-emission area NEA. For example, the light transmittance of the second color filter CF2 may be lower than that of the first color filter CF1 or that of the third color filter CF3.

For convenience of explanation, it is assumed that the second color is green. The human eye may be more sensitive to green than to red or blue. Therefore, to reduce the reflectance of the display panel DP (refer to FIG. 1), it may be most effective to decrease the transmittance of the green color filter. For example, the transmittance of the second color filter CF2 may be reduced by changing the material of the second color filter CF2.

However, in the case where the transmittance of the green color filter is reduced, the color of reflective light (e.g., a reflective color) due to external light may appear close to magenta. Therefore, the green color filter may be disposed in the non-emission area NEA to increase the proportion of green in the reflective light and adjust the reflective color. However, in the description, the reason why the color appears close to magenta is not limited to the transmittance. For example, in the case where the reflective color appears close to magenta although the first, second, and third color filters CF1, CF2, and CF3 have the same transmittance, the second color filter CF2 may be disposed in the non-emission area NEA.

Furthermore, the thickness of the planarization layer OC may be reduced by disposing only the second color filter CF2 in the non-emission area NEA. Hence, the production cost of the display device DD (refer to FIG. 1) may be reduced.

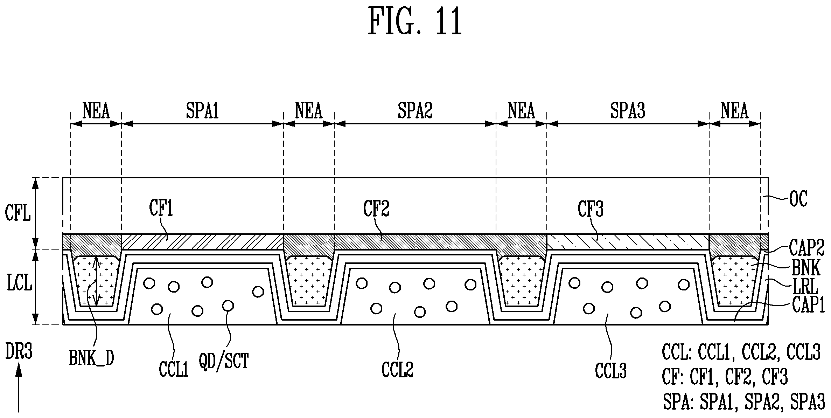

FIG. 11 is a schematic sectional view for describing a thickness BNK_D of the bank BNK of FIG. 10.

Referring to FIG. 11, the thickness BNK_D of the bank BNK may be determined according to the color of reflective light. For example, as the thickness BNK_D of the bank BNK decreases, the quantity of reflective light may be relatively reduced. Therefore, the bank BNK may be formed to have a reduced thickness such that an increase in the proportion of the second color due to the second color filter CF2 in the non-emissive area NEA may be slightly reduced.

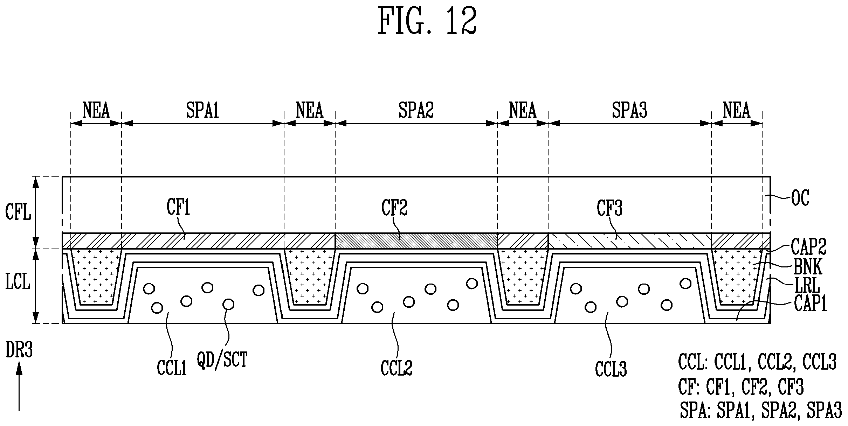

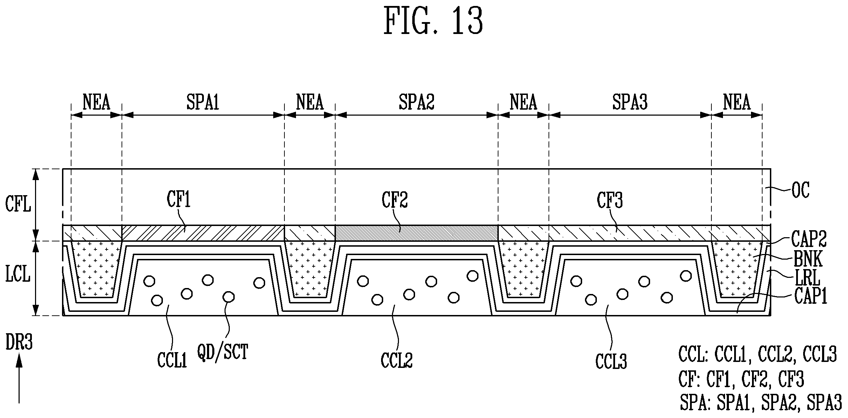

FIGS. 12 and 13 are schematic sectional views illustrating a light conversion layer LCL and a color filter layer CFL of a display device DD in accordance with embodiments.

Since the color filter layer CFL in accordance with the embodiments, other than a color filter CF disposed in the non-emission area NEA, has substantially the same configuration as the color filter layer of FIG. 10, the same reference numerals and symbols are used to designate identical or similar components, and redundant descriptions are omitted for descriptive convenience.

Referring to FIGS. 12 and 13, the color filter CF disposed in the non-emission area NEA may be changed (or modified) according to the reflective color. For example, as illustrated in FIG. 12, in the case where the reflective color appears close to cyan, the first color filter CF1 may be disposed in the non-emission area NEA. For example, as illustrated in FIG. 13, in the case where the reflective color appears close to yellow, the third color filter CF3 may be disposed in the non-emission area NEA.

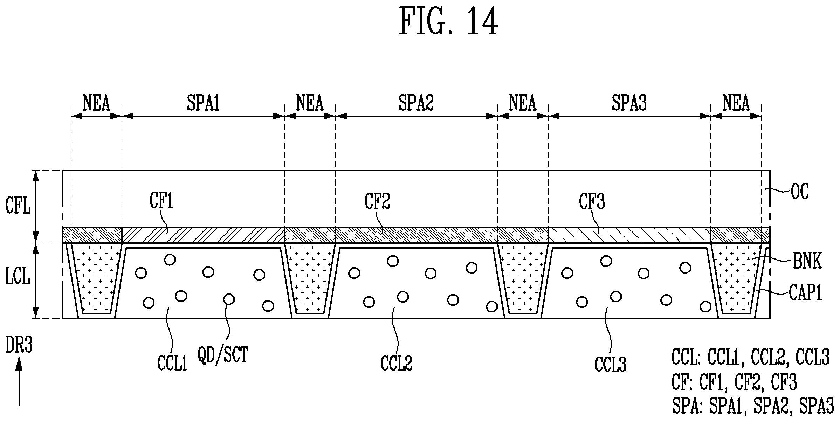

FIG. 14 is a schematic sectional view illustrating a light conversion layer LCL and a color filter layer CFL of the display device DD in accordance with embodiments.

Since the light conversion layer LCL in accordance with the embodiments, other than a structure without the low refractive layer LRL (refer to FIG. 10) and the second capping layer CAP2 (refer to FIG. 10), has substantially the same configuration of the light conversion layer of FIG. 10, the same reference numerals and symbols are used to designate identical or similar components, and redundant descriptions are omitted for descriptive convenience.

Referring to FIG. 14, the bank BNK may be disposed on the first capping layer CAP1, and the color filter CF may be disposed on the first capping layer CAP1 in the sub-pixel area SPA. For example, the color filters CF may contact the first capping layer CAP1 in the sub-pixel area SPA, and may be disposed on the first capping layer CAP1.

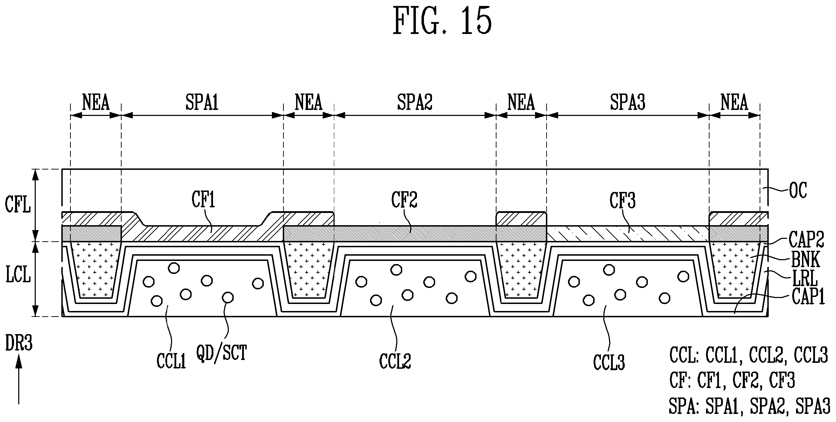

FIGS. 15 to 17 are schematic sectional views illustrating a light conversion layer LCL and a color filter layer CFL of the display device DD in accordance with embodiments.

Since the color filter layer CFL in accordance with the embodiments, other than a color filter CF disposed in the non-emission area NEA, has substantially the same configuration as the color filter layer of FIG. 10, the same reference numerals and symbols are used to designate identical or similar components, and redundant descriptions are omitted for descriptive convenience.

Referring to FIGS. 15 to 17, the color filter CF disposed in the non-emission area NEA may be changed (or modified) according to the reflective color. For example, the color filter CF disposed in the non-emission area NEA may be changed (or modified) according to the color of reflective light.

For example, as illustrated in FIG. 15, in the case where the reflective color appears close to blue, the first color filter CF1 and the second color filter CF2 may be disposed in the non-emission area NEA.

In the embodiments, although the first color filter CF1 is disposed on the second color filter CF2 in the non-emission area NEA, embodiments are not limited thereto. For example, the second color filter CF2 may be disposed on the first color filter CF1.

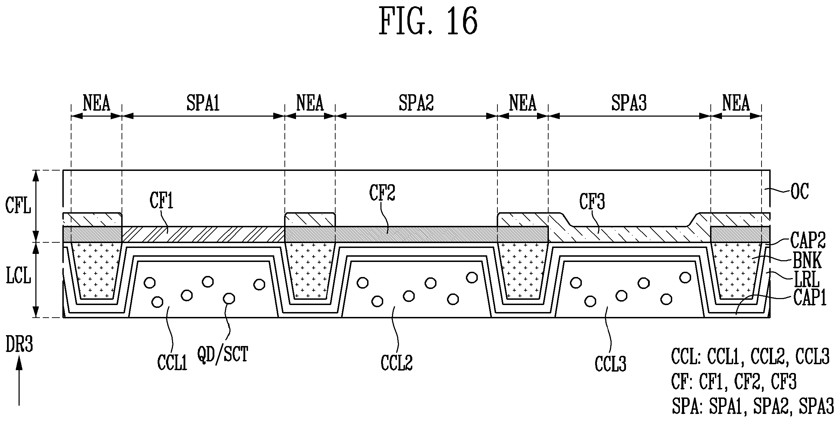

For example, as illustrated in FIG. 16, in the case where the reflective color appears close to red, the second color filter CF2 and the third color filter CF3 may be disposed in the non-emission area NEA.

In the embodiments, although the third color filter CF3 is disposed on the second color filter CF2 in the non-emission area NEA, embodiments are not limited thereto. For example, the second color filter CF2 may be disposed on the third color filter CF3.

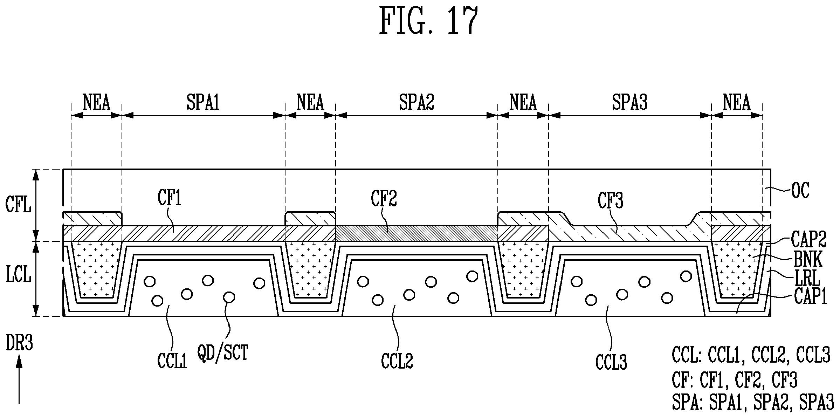

For example, as illustrated in FIG. 17, in the case where the reflective color appears close to green, the first color filter CF1 and the third color filter CF3 may be disposed in the non-emission area NEA.

In the embodiments, although the third color filter CF3 is disposed on the first color filter CF1 in the non-emission area NEA, embodiments are not limited thereto. For example, the first color filter CF1 may be disposed on the third color filter CF3.

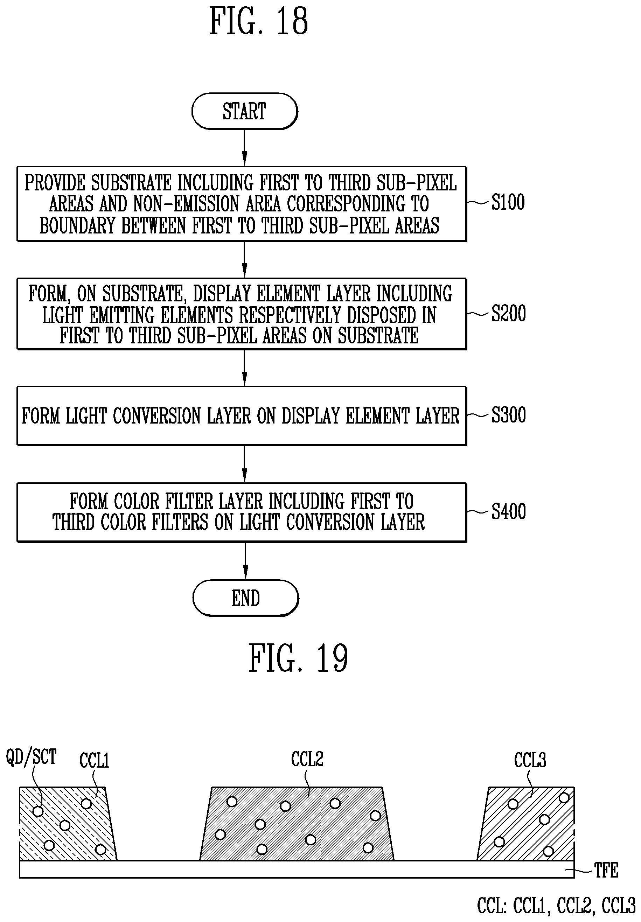

FIG. 18 is a flowchart illustrating a method of fabricating the display device DD in accordance with embodiments.

Referring to FIG. 18, the method of fabricating the display device DD may include a step S100 of providing a substrate SUB including first, second, and third sub-pixel areas SPA1, SPA2, and SPA3 and a non-emission area NEA corresponding to a boundary between the first, second, and third sub-pixel areas SPA1, SPA2, and SPA3, a step S200 of forming a display element layer DPL including light emitting elements LD respectively disposed in the first, second, and third sub-pixel areas SPA1, SPA2, and SPA3 on the substrate SUB, a step S300 of forming a light conversion layer LCL on the display element layer DPL, and a step S400 of forming a color filter layer CFL including first, second, and third color filters CF1, CF2, and CF3 on the light conversion layer LCL.

FIGS. 19 to 23 are schematic diagrams illustrating the step S300 of FIG. 18.

Referring to FIG. 19, the color conversion layer CCL may be formed on the encapsulation layer TFE formed on the display element layer DPL. For example, the color conversion layer CCL may be formed by a photolithography process.

The first color conversion layer CCL1 may be disposed in the first sub-pixel area SPA1. The second color conversion layer CCL2 may be disposed in the second sub-pixel area SPA2. The third color conversion layer CCL3 may be disposed in the third sub-pixel area SPA3.

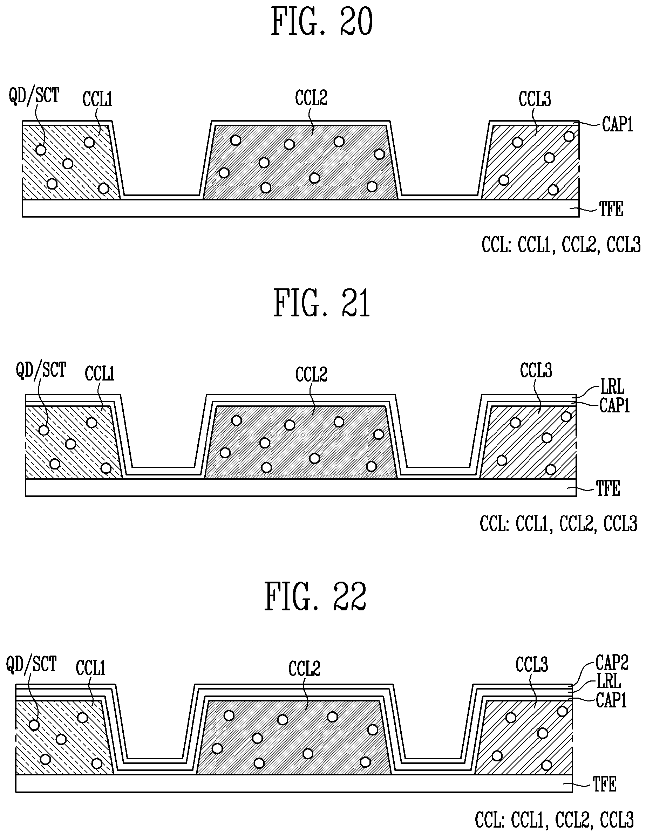

Referring to FIG. 20, the first capping layer CAP1 may be formed to cover the color conversion layer CCL. For example, the first capping layer CAP1 may be disposed on the overall surface of the color conversion layer CCL.

Referring to FIG. 21 and 22, the low refractive layer LRL may be formed on the first capping layer CAP1. The second capping layer CAP2 may be formed on the low refractive layer LRL.

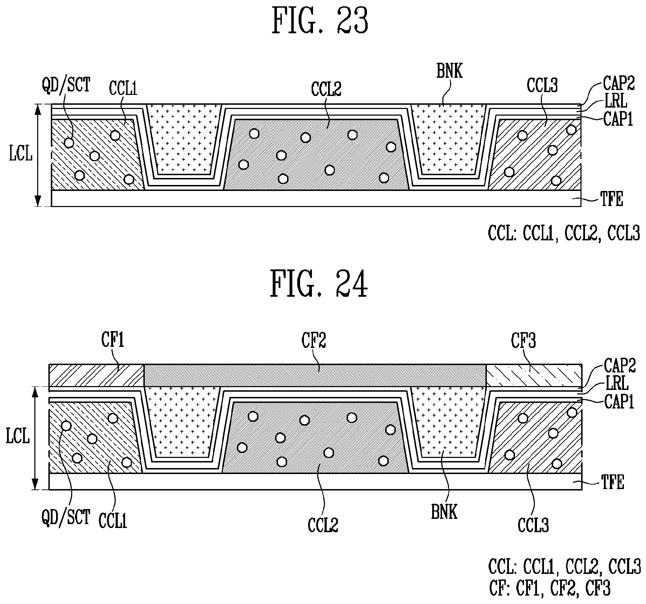

For example, the step of forming the low refractive layer LRL and the second capping layer CAP2 may be omitted. For example, the bank BNK (refer to FIG. 23) may be formed in the non-emission area NEA (refer to FIG. 10) on the first capping layer CAP1, and the color filter CF (refer to FIG. 24) may be formed in the sub-pixel area SPA (refer to FIG. 10) on the first capping layer CAP1.

Referring to FIG. 23, the bank BNK may be formed in the non-emission area NEA (refer to FIG. 10) on the first capping layer CAP1. The second color filter CF2 (refer to FIG. 24) may be formed on the bank BNK.

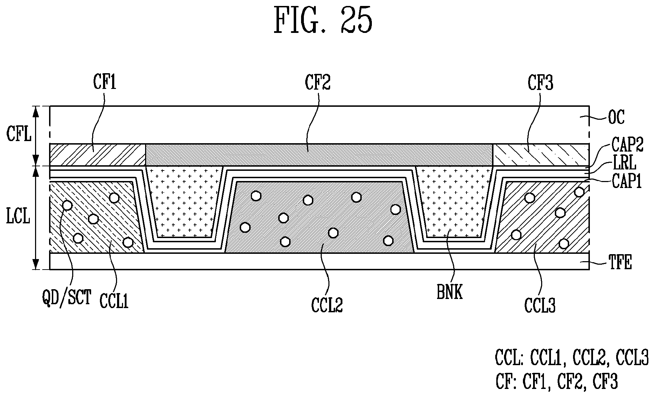

FIGS. 24 and 25 are schematic diagrams illustrating the step S400 of FIG. 18.

Referring to FIGS. 24 and 25, the color filter CF may be formed in the sub-pixel area SPA (refer to FIG. 10) on the first capping layer CAP1. The second color filter CF2 may be formed on the bank BNK in the non-emission area NEA (refer to FIG. 10). The planarization layer OC may be disposed on the color filter CF.

Although certain embodiments and implementations have been described herein, this is only provided for the sake of more general understanding of the disclosure, and those skilled in the art will appreciate that embodiments are not limited to the foregoing embodiments, and other modifications, additions and substitutions are possible.

Therefore, the spirit of the present specification is not limited to the described embodiments, and all matters that are equivalent to or substantially the same as the following claims, as well as the claims themselves, fall within the scope of the spirit of the present specification.

The disclosure may be applied to a display device and an electronic device including the display device. For example, the disclosure may be applied to digital TVs, 3D TVs, cellular phones, smartphones, tablet computers, VR devices, PCs, home appliances, laptop computers, PDAs, portable media players (PMPs), digital cameras, music players, portable game consoles, navigation devices, and so on.

In concluding the detailed description, those skilled in the art will appreciate that many variations and modifications may be made to the embodiments without substantially departing from the principles and spirit and scope of the disclosure.

## Claims

1. A display device comprising:
a substrate including first, second, and third sub-pixel areas and a non-emission area corresponding to a boundary between the first, second, and third sub-pixel areas;
a display element layer including light emitting elements respectively disposed in the first, second, and third sub-pixel areas on the substrate;
a light conversion layer disposed on the display element layer, and including a bank disposed in the non-emission area; and
a color filter layer disposed on the light conversion layer, and including first, second, and third color filters,
wherein one of the first, second, and third color filters is disposed in the non-emission area.

2. The display device of claim 1, wherein
the light conversion layer further includes:
a first layer disposed in the first, second, and third sub-pixel areas; and
a second layer covering the first layer, and
the bank is disposed in the non-emission area on the second layer.

3. The display device of claim 2, wherein at least one of the first, second, and third color filters contacts the second layer.

4. The display device of claim 2, wherein the light conversion layer further includes:
a low refractive layer disposed on the second layer; and
a third layer covering the low refractive layer.

5. The display device of claim 4, wherein at least one of the first, second, and third color filters contacts the third layer.

6. The display device of claim 2, wherein the first layer is formed by a photolithography process.

7. The display device of claim 1, wherein the first, second, and third color filters are formed by a photolithography process.

8. A display device comprising:
a substrate including first, second, and third sub-pixel areas and a non-emission area corresponding to a boundary between the first, second, and third sub-pixel areas;
a display element layer including light emitting elements respectively disposed in the first, second, and third sub-pixel areas on the substrate;
a light conversion layer disposed on the display element layer, and including a bank disposed in the non-emission area; and
a color filter layer disposed on the light conversion layer, and including first, second, and third color filters,
wherein two of the first, second, and third color filters are disposed in the non-emission area.

9. The display device of claim 8, wherein
the first and the second color filters are disposed in the non-emission area, and
the first color filter is disposed on the second color filter in the non-emission area.

10. The display device of claim 9, wherein
the light conversion layer further includes:
a first layer disposed in the first, second, and third sub-pixel areas; and
a second layer covering the first layer,
the bank is disposed in the non-emission area on the second layer.

11. The display device of claim 10, wherein at least one of the first, second, and third color filters contacts the second layer.

12. The display device of claim 10, wherein the light conversion layer further includes:
a low refractive layer disposed on the second layer; and
a third layer covering the low refractive layer.

13. The display device of claim 12, wherein at least one of the first, second, and third color filters contacts the third layer.

14. The display device of claim 10, wherein the first layer is formed by a photolithography process.

15. The display device of claim 8, wherein the first, second, and third color filters are formed by a photolithography process.

16. A method of fabricating a display device, the method comprising:
providing a substrate including first, second, and third sub-pixel areas and a non-emission area corresponding to a boundary between the first, second, and third sub-pixel areas;
forming, on the substrate, a display element layer including light emitting elements respectively disposed in the first, second, and third sub-pixel areas on the substrate;
forming, on the display element layer, a light conversion layer including a bank disposed in the non-emission area; and
forming, on the light conversion layer, a color filter layer including first, second, and third color filters,
wherein forming the color filter layer comprises forming one of the first, second, and third color filters in the non-emission area on the bank.

17. The method of claim 16, wherein
forming the light conversion layer comprises:
forming a first layer in the first, second, and third sub-pixel areas; and
forming a second layer covering the first layer,
the bank is formed in the non-emission area on the second layer.

18. The method of claim 17, wherein
forming the light conversion layer comprises:
forming a low refractive layer on the second layer; and
forming a third layer covering the low refractive layer,
at least one of the first, second, and third color filters contacts the third layer.

19. The method of claim 17, wherein the first layer is formed by a photolithography process.

20. The method of claim 16, wherein the first, second, and third color filters are formed by a photolithography process.
